Europäisches Patentamt

European Patent Office

Office européen des brevets

(11) Publication number: **0 164 978**

A1

# EUROPEAN PATENT APPLICATION

(21) Application number: 85303882.6

(22) Date of filing: 03.06.85

(51) Int. Cl.⁴: **H 04 N 5/10**
**H 03 K 21/00**

(30) Priority: 05.06.84 GB 8414314

(43) Date of publication of application:
18.12.85 Bulletin 85/51

(84) Designated Contracting States:
DE FR IT NL

(71) Applicant: MOTOROLA, INC.
1303 East Algonquin Road
Schaumburg, Illinois 60196(US)

(72) Inventor: Jobling, David Trevor
7 Avenue Soret
CH-1203 Geneva(CH)

(72) Inventor: Newton, Anthony David
Les Jordils
CH-1261 Le Vaud(CH)

(74) Representative: Ibbotson, Harold et al,
Motorola Ltd Patent and Licensing Operations - Europe
Jays Close Viables Industrial Estate
Basingstoke Hampshire RG22 4PD(GB)

(54) Vertical synchronisation pulse separator.

(57) A vertical synchronisation separator includes an up/down counter which counts up when a composite sync signal fed to its input has one logic state and counts down when the composite sync signal has a second logic state, a decoder in the form of a gating circuit providing a logic (1) output when the count of the up/down counter exceeds a predetermined count.

- 1 -

0164978

# VERTICAL SYNCHRONISATION PULSE SEPARATOR

## FIELD OF INVENTION

The present invention relates to digital pulse separator for separating pulses of a predetermined logic value from a composite signal and relates particularly but not exclusively to a vertical synchronisation pulse separator for separating field synchronisation pulses from a composite synchronisation signal in a television signal.

## BACKGROUND ART

As is well known, television signals are transmitted as separate lines of information, a complete picture, containing 625 or 525 lines depending upon the particular television standard.

Each line which is transmitted contains a line synchronisation pulse together with analogue video information. At the end of every field in which a vertical scan of the picutre is made, field synchronisation is effected usually by means of a group of five longer field synchronisation pulses.

In order for satisfactory operation of a television receiver the field and line synchronisation pulses need to be separated from one another.

This is accomplished firstly by removing the video information from the received signal to provide a composite synchronisation signal containing both line and field synchronisation pulses.

The composite synchronisation signal has formerly been applied to an integrator. The integrator does not respond significantly to the line synchronisation pulses which are singular and relatively short, but during the field synchronistion period the output of the integrator rises significantly in response to the five longer pulses. Detection of the field synchronisation pulses is affirmed when the output level of the integrator has risen above a predetermined voltage level.

A problem with this known sync separation method is that an integrating capacitor is required. This does not easily facilitate forming the sync separator circuit as part of a monolithic integrated circuit since the capacitor would need to be an off chip component.

The present invention seeks to provide a verticl sync separator which is suitable for manufacturing as part of an integrated circuit and in which the above mentioned disadvantage is mitigated.

BRIEF DESCRIPTION OF INVENTION

In accordance with one aspect of the invention there is provided a digital pulse separator for separating pulses of a predetermined logic value from a composite signal the circuit comprising a counter responsive to the composite signal and means responsive to the state of the counter for indicating the reception of the said pulses when the count of the counter exceeds a predetermined value.

In accordance with an embodiment of the present invention a vertical synchronisation pluse separator comprises a counter responsive to synchronisation pulses present in a composite synchronisation input signal and means responsive to the state of the counter for indicating the reception of field synchronisation pulses when the count of the counter exceeds a predetermined value.

- 3 -    0164978

## BRIEF DESCRIPTION OF THE DRAWINGS

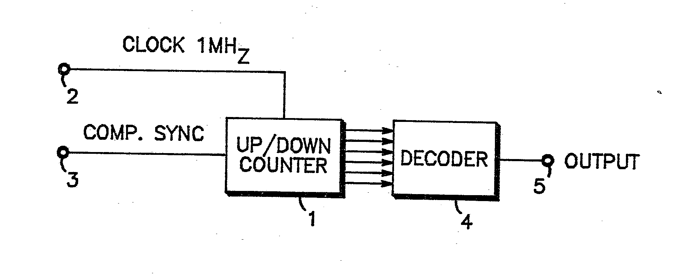

An exemplary embodiment of the invention will now be described with reference to the accompany single figure drawing which illustrates schematically a preferred embodiment of a vertical sync separator in accordance with the present invention.

## DETAILED DESCRIPION OF THE INVENTION

Referring to the Drawing, an up down counter 1 is clocked at a rate of $1MH_z$ by means of a clock signal applied at a terminal 2 and counts either up or down in dependence upon the logical state of a composite synchronisation signal applied to the input terminal 3 of the counter.  The state of the counter is sampled by a decoder4 which has an output connected to output terminal 5.

When the terminal 3 is at a logical '0' state the counter is clocked up by the clock signal applied to the terminal 3 whilst when the terminal 3 is at a logical '1' level the counter counts down.  The counter stops counting when its count reaches either an all '1' or an all '0' state but recommences counting when the input at the terminal 3 changes state.

The count of the counter is sampled and decoded by the decoder 4 and when the count exceeds a predetermined value a logical '1' appears at the output 5 of the circuit.

The decoder is typically implemented by gates which gate together the outputs of the counter to provide a logic 1 output for any predetermined set of outputs of the counter.

When a synchronisation pulse, which may be either a short line synchronisation pulse or a longer field synchronisation pulse, appears at the terminal 3 the logical level at that terminal will go low and the counter 1 will start to count up. During each line synchronisation pulse the counter 1 will only count up to a relatively low value eg four, before the end of the sync pulse at which time the logical level at the terminal 3 will change and the counter will commence counting down. During the long field synchronisation pulses the counter will count up to a much higher value, for example 40 before it is reversed. The stages of the counter are monitored by the decoder 4 and when the decoded count exceeds a predetermined value typically a count of 12, a logical '1' output appears at the output terminal 5 indicating the reception of a field synchronisation pulse.

Although the invention is particularly applicable to a television receiver it is equally applicable to a video recorder. The invention is particularly applicable to fabrication as an integrated circuit as part of a single chip television signal processing system.

Also the invention may be used to separate digital signals of a predetermined logic value from a composite signal including logic 1's and 0's or from a signal which may include noise.

The invention is applicable for use in a data slicer for a teletext receiver.

- 5 -

0164978

CLAIMS

1.      A digital pulse separator for separating pulses of a predetermined logic value from a composite signal the circuit comprising a counter responsive to the composite signal and means responsive to the state of the counter for indicating the reception of the said pulses when the count of the counter exceeds a predetermined value.

2.      The digital pulse separator of claim 1 in the form of a vertical synchronisation pulse separator comprising a counter responsive to synchronisation pulses present in a composite synchronisation signal and means responsive to the state of the counter for indicating the reception of field synchronisation pulses when the count of the counter exceeds a predetermined value.

3.      The synchronisation pulse separator of claim 2 wherein the counter comprises an up/down counter having a first input for receiving the composite synchronisation signal and a clock input, the counter being operative to count in a first direction in response to the composite synchronisation signal having a first logic state and in a second direction in response to the composite synchronisation having a second logic state.

4.      The synchronisation pulse separator of claim 2 or 3 wherein the means responsive to the state of the counter comprises decoding means coupled to each stage of the counter and operative to provide an output having a predetermined logic state in response to the stages of counter indicating a count exceeding the said predetermined value.

5.      The synchronisation pulse separator of claim 4 wherein the decoding means comprises gating means for gating together outputs from the stages of the counter and operative to provide the said output in response to the said stages assuming predetermined logic values.

6.      The synchronisation pulse separator of any preceding claim and provided in integrated circuit form.

7.      A television receiver including the synchronisation pulse separator of any preceding claim.

0164978

CLOCK 1MH$_Z$

2

COMP. SYNC

3

UP/DOWN COUNTER

1

DECODER

4

OUTPUT

5

## DOCUMENTS CONSIDERED TO BE RELEVANT

EP 85303882.6

| Category | Citation of document with indication, where appropriate, of relevant passages | Relevant to claim | CLASSIFICATION OF THE APPLICATION (Int. Cl.4) |
|---|---|---|---|
| X | DE - A1 - 3 037 987 (PHILIPS)<br>* Fig. 2; page 6, line 1 - page 7, line 32 * | 1,2 | H 04 N 5/10<br>H 03 K 21/00 |
| X | US - A - 3 925 613 (KOKADO)<br>* Fig. 1; column 3, line 63 - column 4, line 44 * | 1,2 | |
| Y | DE - A - 2 242 935 (WOODWARD)<br>* Fig. 1; page 9, lines 4-10, 21-29; page 14, lines 24-30 * | 1-7 | |
| Y | DE - A1 - 2 530 438 (SIEMENS)<br>* Fig. 2; page 5, lines 10-34; page 6, lines 1,2 * | 1-7 | |

**TECHNICAL FIELDS SEARCHED (Int. Cl.4)**

H 04 N 5/00

H 03 K 5/00

H 03 K 21/00

H 03 K 23/00

H 04 L 7/00

The present search report has been drawn up for all claims

| Place of search | Date of completion of the search | Examiner |
|---|---|---|
| VIENNA | 28-08-1985 | BENISCHKA |